Europäisches Patentamt

European Patent Office

Office européen des brevets

(19)

(11) Publication number: **0 206 203 B1**

# EUROPEAN PATENT SPECIFICATION

(45) Date of publication of patent specification: **30.03.94**    (51) Int. Cl.⁵: **H04L 27/18**, G11B 20/10

(21) Application number: **86108197.4**

(22) Date of filing: **16.06.86**

(54) **Recording and reproducing apparatus using a modulator/demodulator for Offset Ouadrature Differential Phase-Shift Keying.**

(30) Priority: **21.06.85 JP 134054/85**
**21.06.85 JP 134057/85**

(43) Date of publication of application:
**30.12.86 Bulletin 86/52**

(45) Publication of the grant of the patent:
**30.03.94 Bulletin 94/13**

(84) Designated Contracting States:
**AT DE FR GB IT NL**

(56) References cited:
**EP-A- 0 143 654**
**US-A- 4 092 491**
**US-A- 4 501 002**

**IEEE TRANSACTIONS ON MICROWAVE THE-
ORY AND TECHNIOUES, vol. MTT-29, no. 5,
May 1981, pages 439-450, IEEE, New York,
US; J. HENAFF et al.: "Implementation of
satellite communication systems using sur-
face acoustic waves"**

(73) Proprietor: **HITACHI, LTD.**
**6, Kanda Surugadai 4-chome
Chiyoda-ku, Tokyo 100(JP)**

(72) Inventor: **Amada, Nobutaka**
**Hitachi Hachimanyama Apt. 552
1545, Yoshida-cho
Totsuka-ku Yokohama-shi Kanagawa-ken(JP)**
Inventor: **Noguchi, Takaharu**
**Totsuka Highrise 135
884-1, Kamikurata-cho
Totsuka-ku Yokohama-shi Kanagawa-ken(JP)**
Inventor: **Kimura, Hiroyuki**
**1-12-1725, Yurigaoka
Ninomiya-cho
Naka-gun Kanagawa-ken(JP)**
Inventor: **Kobayashi, Masaharu**
**Hitachi Hachimanyama Apt. 331
1545, Yoshida-cho
Totsuka-ku Yokohama-shi Kanagawa-ken(JP)**
Inventor: **Arai, Takao**
**65-24, Ibukino
Midori-ku
Yokohama-shi Kanagawa-ken(JP)**
Inventor: **Yumde, Yasufumi**
**1257-1, Yoshida-cho
Totsuka-ku
Yokohama-shi Kanagawa-ken(JP)**
Inventor: **Miura, Kuniaki**
**3173-1, Godai, Naka-cho
Naka-gun Ibaraki-ken(JP)**

(74) Representative: **Altenburg, Udo, Dipl.-Phys. et al**
**Patent- und Rechtsanwälte,**
**Bardehle . Pagenberg . Dost . Altenburg .**
**Frohwitter . Geissler & Partner,**
**Postfach 86 06 20**
**D-81633 München (DE)**

## Description

### BACKGROUND OF THE INVENTION

The present invention relates to an information recording and reproducing apparatus using an offset quadrature differential phase-shift keying modulator/demodulator adapted for transmitting and receiving information via a non-linear channel.

In the field of digital radio communication, a quadrature differential phase-shift keying (QDPSK) system is widely employed today due to some advantages including the capability of relatively narrow band transmission and the simplified structure of a demodulator. In such QDPSK system, however, passage of information through a non-linear channel causes an increase in the bandwidth and deteriorates the coding error rate characteristic. These disadvantages raise a serious problem to be solved in a transmitter for satellite communication, mobile communication or the like where the bandwidth is limited and the carrier-to-noise power ratio (C/N) is not settable to be so high.

In view of the circumstances mentioned above, an offset QPSK system is attracting attention of late. This system is dealt with in the following: H. Suzuki et al. "Fundamental Properties of Narrowband Digital Angle Modulations", Shingaku Giho, CS-81-52, 1981; and R. K. Kwan, "The Effects of Filtering and Limiting A Double Binary PSK Signal", IEEE Trans. on AES, July 1969. According to this system, data of an in-phase (P) channel and a quadrature (Q) channel are modulated in such a manner that the code change points thereof have a mutual deviation of one half data period, wherein the envelopes of the modulated waves are rendered free from zero-crossing, and the band is not so widened with passage of the data via the non-linear channel.

EP-A-143 654 discloses a recording (and reproducing) apparatus according to the preambles of claims 1,2 and 7.

### SUMMARY OF THE INVENTION

It is an object of the invention to provide an information recording and reproducing apparatus equipped with an offset quadrature differential PSK modulator/demodulator adapted for recording and reproducing digital information.

In order to achieve the above object, the present invention is so contrived that on its modulator side, data of the in-phase channel and the quadrature channel are modulated after differential coding with the respective code change points being deviated from each other by one half data period, while on its demodulator side, the detected data are converted into serial data after differential decoding in the in-phase and quadrature channels.

In the present invention, the offset quadrature differential PSK modulator comprises a first converter for converting the input serial digital data into first and second signals which correspond respectively to the even and odd bits of the serial digital data with the code change points thereof having a mutual deviation of one half data period; first and second differential coders for differentially coding the first and second signals respectively; and a quadrature modulator for balanced-modulating two quadrature carriers having a $\pi/2$ phase difference from each other by the outputs of the first and second differential coders.

Meanwhile, the offset quadrature differential PSK demodulator in the present invention comprises a coherent detector for receiving the signal transmitted from the aforesaid offset quadrature differential PSK modulator and phase-detecting the received signal with two quadrature carriers having a $\pi/2$ phase difference from each other; first and second code discriminators for discrimianting between positive and negative polarities of the first and second output signals from the coherent detector, and converting such signals into first and second digital signals respectively; first and second differential decoders for differentially decoding the first and second digital signals respectively; and a second converter for alternately selecting the output signals of the first and second differential decoders at a speed twice the data speed of such output signals and converting them into serial signals.

The present invention further provides a magnetic recording/reproducing apparatus which is capable of magnetically recording video signal and digital audio signal, wherein the aforesaid offset quadrature differential PSK modulator is used as a modulation means in the digital audio recording line, while the aforesaid offset quadrature differential PSK demodulator is used as a demodulation means in the digital audio reproducing line. In another magnetic recording/reproducing apparatus of the invention, a limiter circuit or a combination of a limiter circuit and a band-pass filter is disposed in a stage posterior to the aforesaid offset quadrature differential PSK modulator in the digital audio recording line.

The differential coding executed by the first and second differential coders constituting the offset quadrature differential PSK modulator is preferably such as to satisfy the conditions of Eqs. (1) and (2) which will be described later in detail. And similarly the differential decoding executed by the offset quadrature differential PSK demodulator is preferably such as to satisfy the conditions of Eqs. (6) and (7) or Eqs. (8) and (9) which will also be described later in detail.

The above-mentioned magnetic recording/reproducing apparatus for multiply recording video signal and digital audio signal is defined as a multilayer recording and reproducing type which is capable of recording the video signal in a surface part of a magnetic recording medium while recording the digital audio signal in a deep part thereof.

## BRIEF DESCRIPTION OF THE DRAWINGS

Fig. 1A is a circuit diagram showing an embodiment of the offset quadrature differential PSK modulator according to the present invention;

Fig. 1B is a circuit diagram showing an embodiment of the offset quadrature differential PSK demodulator according to the invention;

Fig. 2 is a waveform chart illustrating the operations performed in principal portions of the offset quadrature differential PSK modulator and demodulator shown in Figs. 1A and 1B;

Fig. 3 is a circuit diagram showing an exemplary configuration of principal components of the offset quadrature differential PSK modulator shown in Fig. 1A;

Fig. 4 is a waveform chart illustrating the operations in principal portions of the circuit configuration shown in Fig. 3;

Fig. 5 is a circuit diagram showing an exemplary configuration of principal components of the offset quadrature differential PSK demodulator shown in Fig. 1B;

Fig. 6 is a waveform chart illustrating the operatings in principal portions of the circuit configuration shown in Fig. 4;

Fig. 7 is a block diagram of an embodiment of the invention in an exemplary case where the offset quadrature differential PSK modulator and demodulator thereof are applied to a digital audio magnetic multilayer recording/reproducing apparatus;

Fig. 8 graphically shows the frequency characteristics of digital audio signal and video signal recorded on a magnetic recording medium in the embodiment of Fig. 7;

Fig. 9 graphically shows the relationship between a recording current and a reproduced output level in the characteristic of an audio head;

Fig. 10 is a waveform chart showing the envelopes of offset Q(D)PSK modulated waves and QPSK modulated waves;

Fig. 11 graphically shows the spectrum of the offset Q(D)PSK modulated wave;

Fig. 12 graphically shows the frequency characteristic of a BFP 123 disposed on the digital audio recording side in the embodiment of Fig. 7;

Fig. 13 is a circuit diagram showing an exemplary embodiment of a limiter 124 disposed on the digital audio recording side in the embodiment of Fig. 7; and

Fig. 14 is a circuit diagram showing another embodiment of the limiter 124 in Fig. 7.

## DETAILED DESCRIPTION OF THE PREFERRED EMBODIMENTS

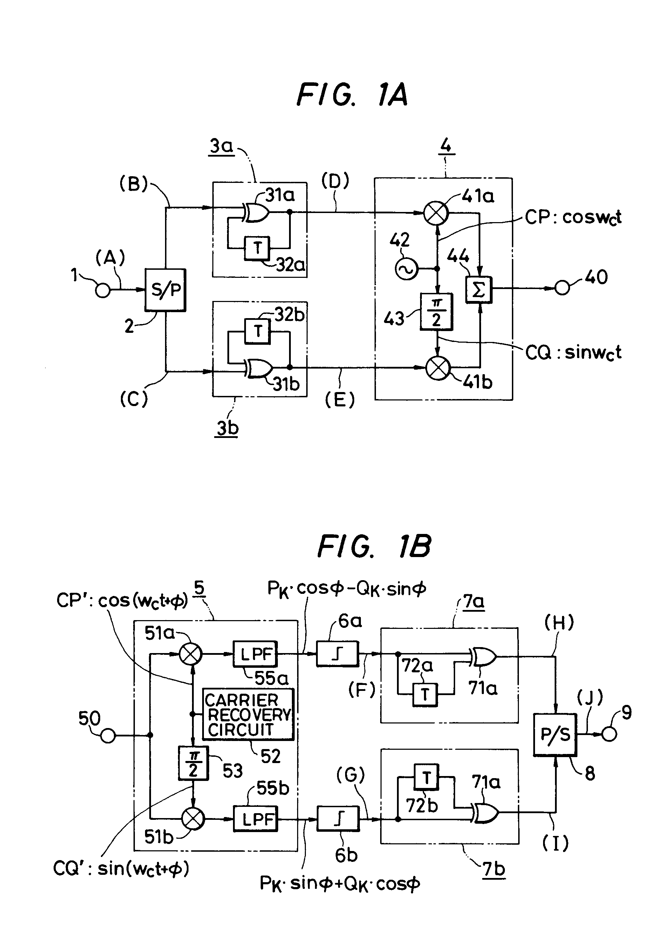

Figs. 1A and 1B are respective circuit diagrams of a modulator and a demodulator for offset quadrature differential PSK according to the present invention.

First in Fig. 1A, there are shown an input terminal 1 for digital data (A) to be transmitted; a serial-parallel converter circuit 2 for converting the input serial data (A) into parallel data (B) and (C) of two systems; differential coders 3a and 3b for converting the codes of parallel data (B) and (C) into coded changes; a quadrature modulator 4 for balance-modulating, by two carriers having a $\pi/2$ phase difference from each other, the parallel data (D) and (E) differentially coded independently of each other; and an output terminal 40 for the modulated signal. In the above, the differential coder 3a comprises an EOR circuit 31a and a delay circuit 32a, while the differential coder 3b comprises an EOR circuit 31b and a delay circuit 32b. And the quadrature modulator 4 comprises balanced modulators 41a and 41b, a carrier oscillator 42, a $\pi/2$ phase shifter 43 and an adder 44. Thus the component elements mentioned constitute an offset quadrature differential PSK (O-QDPSK) modulator.

In Fig. 1B are shown an input terminal 50 for the O-QDPSK modulated signal; a coherent detector 5 for phase-detecting the input modulated signal by two quadrature carriers phase-locked to the modulated signal; code discriminators 6a and 6b for discriminating between the positive and negagive polarities of the phase-detected input signals of two systems by the timing synchronized with the speed of the parallel data transmitted thereto, and converting the input signals to digital signals; differential decoders 7a and 7b for inversely converting the respective coded changes of the digital signals (F) and (G) of two systems to the former codes thereof; a parallel-serial converter 8 for converting the decoded parallel data (H) and (I) to serial data (J); and an output terminal 9 for the finally demodulated digital data (J). The coherent detector 5 comprises phase detectors 51a and 51b, a carrier recovery circuit 52, a $\pi/2$ phase shifter 53 and low-pass filters 55a and 55b. And the differential decoder 7a comprises an EOR circuit 71a and a delay circuit 72a, while the differential decoder 7b comprises an EOR circuit 71b and a delay circuit 72b. Thus the component elements mentioned constitute an O-QDPSK demodulator.

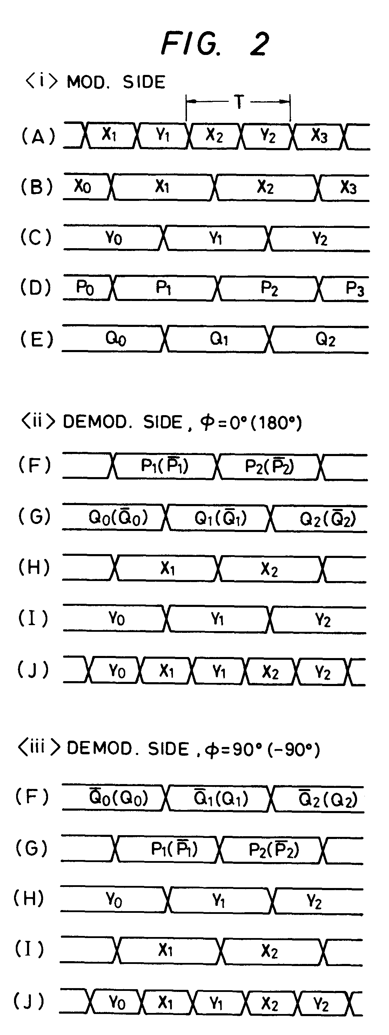

Fig. 2 is a waveform chart illustrating the operations performed in individual portions of the circuit shown in Fig. 1. Hereinafter the operation of this embodiment will be described below with reference thereto.

In Fig. 2, [i] shows operation waveforms on the modulator side, while [ii] and [iii] show those on the demodulator side. The waveforms of [ii] represent a case where the phase difference $\phi$ of the carrier recovered in the demodulator is 0° or 180° with respect to the carrier phase in the modulator, and those of [iii] represent another case where the above phase difference $\phi$ is ±90°. First on the modulator side in [i], the input digital data (A) is divided into 2-bit groups each consisting of a preceding bit Xk and a following bit Yk (in which k is an integer), and the parallel data (B) and (C) converted by the serial-parallel converter 2 are output alternately with a mutual deviation of one half data period (T/2) as shown. Subsequently the parallel data Xk and Yk are converted into data Pk and Qk by the differential coders 3a and 3b respectively, as given below by logical expressions:

$$Pk = Xk \oplus Pk - 1 \qquad (1)$$

$$Qk = Yk \oplus Qk - 1 \qquad (2)$$

where $\oplus$ means exclusive ORed.

The data Pk and Qk thus obtained are modulated by the quadrature modulator 4. The modulated signals are expressed as Eq. (3) below when the in-phase carrier CP is cos $\omega$ct and the quadrature carrier CQ is sin $\omega$ct (in which $\omega$c is the carrier angular frequency).

$$Pk \cdot \cos \omega ct + Qk \cdot \sin \omega ct \qquad (3)$$

Subsequently, on the demodulator side, the modulated signal given by Eq. (3) is detected by the coherent detector 5. In this stage, the detected output signals are expressed as follows when the in-phase carrier CP' and the quadrature carrier CQ' recorded by the circuit 52 are cos ($\omega$ct + $\phi$) and sin ($\omega$ct + $\phi$), respectively.

$$Pk \cdot \cos \phi - Qk \cdot \sin \phi \qquad (4)$$

$$Pk \cdot \sin \phi + Qk \cdot \cos \phi \qquad (5)$$

During the normal operation of the carrier recovery circuit 52, the phase difference $\phi$ as compared with the modulator side is a value of 0°, ±90° or ±180°.

Fig. 2 [ii] shows the operation waveforms in a case where such phase difference $\phi$ is 0° or 180°. For example, when the phase difference $\phi$ is 0°, data Pk and Qk appear in the output signals (F) and (G) of the code discriminators 6a and 6b. Then such data are processed by the differential decoders 7a and 7b, so that the former parallel data Xk and Yk are decoded in the output signals (H) and (I) respectively. This process is expressed by logical equations as follows:

$$Pk \oplus Pk - 1 = (Xk \oplus Pk - 1) \oplus Pk - 1 \equiv Xk \qquad (6)$$

$$Qk \oplus Qk - 1 = (Yk \oplus Qk - 1) \oplus Qk - 1 \equiv Yk \qquad (7)$$

When the phase difference $\phi$ is 180°, data $\overline{Pk}$ and $\overline{Qk}$ appear in the signals (F) and (G) as is obvious from Eqs. (4) and (5), but the former data Xk and Yk are decoded in the signals (H) and (I) by the differential decoders 7a and 7b. The above is expressed by the following logical equations:

$$\overline{Pk} \oplus \overline{Pk-1} = \overline{Xk \oplus Pk-1} \oplus \overline{Pk-1}$$

$$= Xk \oplus \overline{Pk-1} \oplus \overline{Pk-1}$$

$$\equiv Xk \qquad\qquad \dots\dots (8)$$

$$\overline{Qk} \oplus \overline{Qk-1} = \overline{Yk \oplus Qk-1} \oplus \overline{Pk-1}$$

$$= Yk \oplus \overline{Qk-1} \oplus \overline{Qk-1}$$

$$\equiv Yk \qquad\qquad \dots\dots (9)$$

The former parallel data Xk and Yk thus resumed are converted into serial data by the parallel-serial converter 8 to obtain final demodulated data (J).

Similarly to the above, when the phase difference $\phi$ is 90°, merely the channels relative to Xk and Yk are reversed as shown in Fig. 2 [iii] while the sequential relationship between Xk and Yk is maintained, so that no problem is raised by executing parallel-serial conversion of the data in such order. This method will be described later in detail.

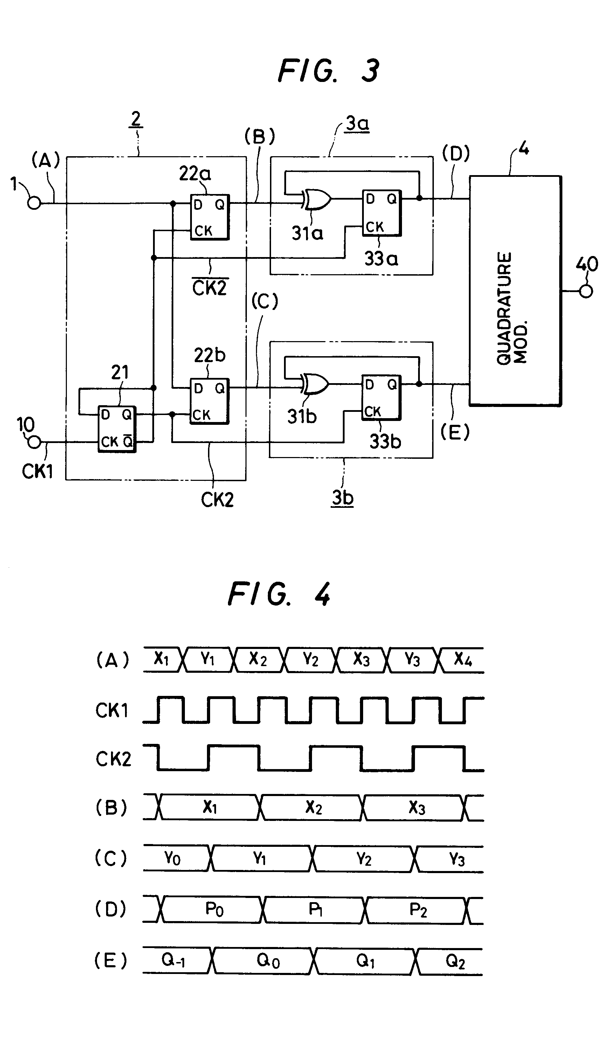

Fig. 3 is an exemplary circuit diagram of the modulator according to the present invention. In this embodiment are shown D-type flip-flops (D-FF) 21, 22a, 22b, 33a, 33b, and an input terminal 10 for clock pulses CK1 of the input data (A). Fig. 4 is a waveform chart showing individual operations performed in the circuit of Fig. 3. Hereinafter such operations will be described with reference to Fig. 4. The clock pulses CK1 fed to the input terminal 10 are frequency-divided by two in the D-FF 21 to produce clock pulses CK2 and $\overline{CK2}$. The input serial data (A) is latched by the D-FF 22a and 22b synchronously with the rising edges of the clock pulses CK2 and $\overline{CK2}$, whereby parallel data Xi and Yi are obtained. In the differential coders 3a and 3b, D-FF 33a and 33b are employed to constitute the delay circuits 32a and 32b shown in the embodiment of Fig. 1, and the operations thereof remain exactly the same. In the circuit configuration of Fig. 3, Pk and Qk are outputted with a delay of one period from Xk and Yk respectively as shown in Fig. 4, but there arises no problem at all. The parallel data Pk and Qk thus coded differentially are modulated by the quadrature modulator 4. According to this embodiment, in the manner mentioned above, the O-QDPSK modulator can be realized with a simplified constitution.

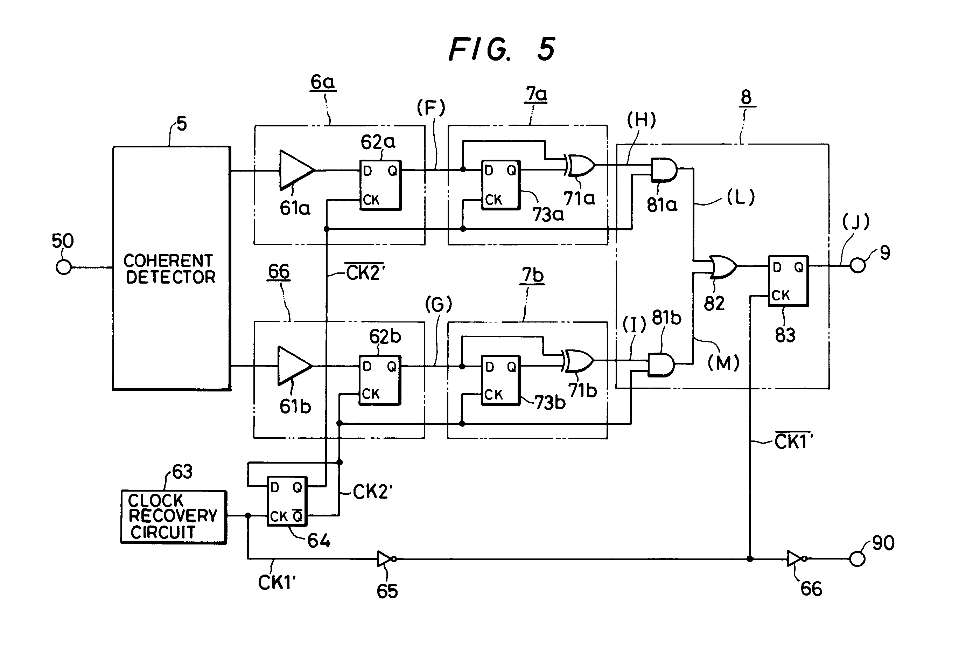

Fig. 5 is an exemplary circuit diagram of the demodulator according to the present invention. In this embodiment are shown comparators 61a and 61b; D-FF 62a, 62b, 64, 73a, 73b and 83; a clock recovery circuit 63; inverter circuits 65 and 66; AND circuits 81a and 81b; an OR circuit 82; and an output terminal 90 for clock pulses CK1' bit-synchronized with the demodulated data (J). The signals of two systems detected by the coherent detector 5 are converted into digital signals (F) and (G) by the code discriminators 6a and 6b which are composed respectively of comparators 61a, 61b and D-FF 62a, 62b. Such conversion is executed synchronously with the rising edges of clock pulses $\overline{CK2'}$ and CK' which are obtained from the D-FF 64 through 1/2 frequency division of the clock pulses CK1' recovered by the clock recovery circuit 63. The differential decoders 7a and 7b are so constituted that the aforesaid delay circuits 72a and 72b in the embodiment of Fig. 1 are replaced with D-FF 73a and 73b, and the operations thereof remain exactly the same. The decoded parallel data (H) and (J) and the recovered clock pulses $\overline{CK2'}$ and CK2' are input respectively to the AND circuits 81a and 81b, from which AND outputs are produced. The two signals (L) and (M) are fed to the OR circuit 82 to be logically summed and then are latched by the D-FF 83 synchronously with the rising edges of the recovered clock pulses $\overline{CK1'}$, whereby demodulated serial data is finally obtained.

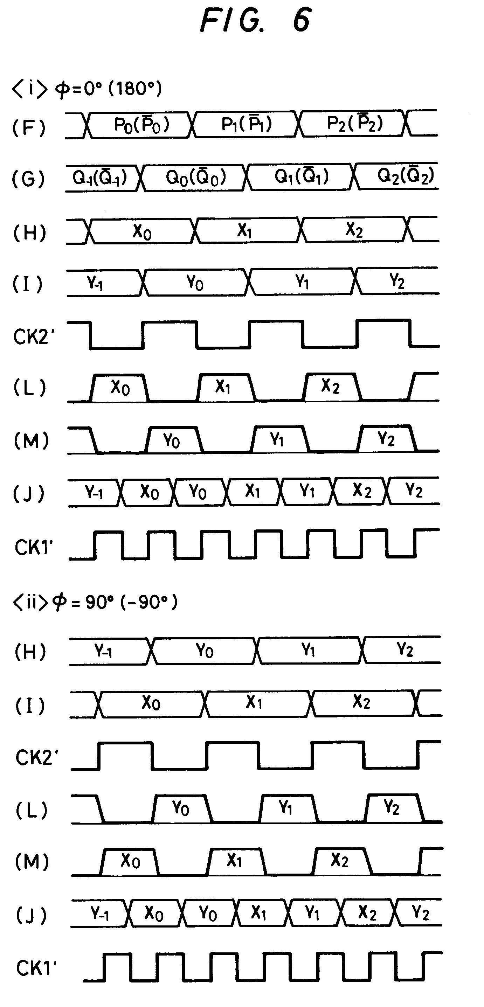

Fig. 6 is a waveform chart showing how such operations are performed, in which [i] represents a case where the phase difference $\phi$ of the recovered carrier is 0° or 180°, and [ii] represents another case where the above phase difference $\phi$ is ±90°. Thus, regardless of the value of such phase difference $\phi$, the transmitted data can be demodulated without any error.

The differential procedure is applicable also to the O-QPSK system which is advantageous with respect to the non-linear transmission path, so that it becomes unnecessary to detect the absolute phase or to maintain the phase difference $\phi$ of the recovered carrier at 0° under control, thereby achieving great effects in simplifying the demodulator circuit configuration.

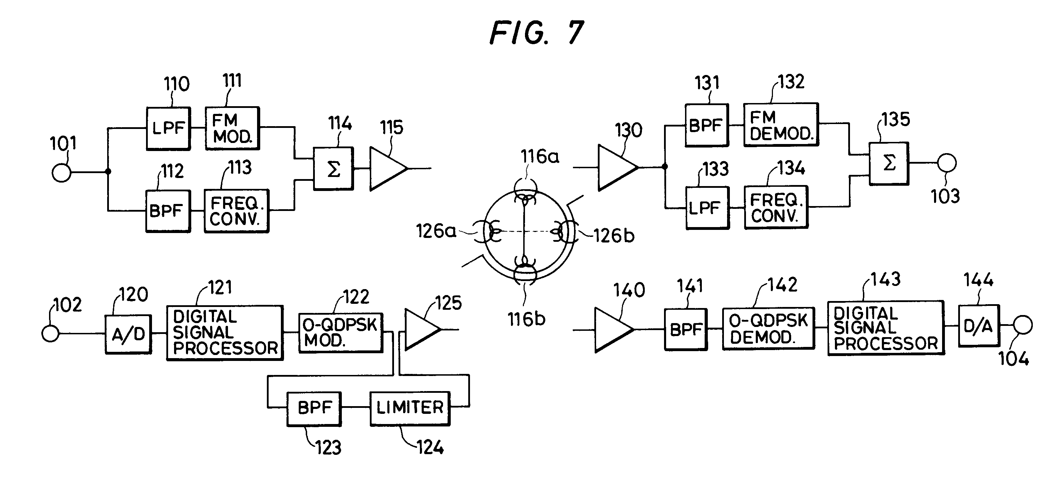

Now, with reference to Fig. 7, a description will be given on another embodiment where the O-QDPSK system of this invention is applied to a PCM audio magnetic multilayer recording/reproducing apparatus. In the diagram are shown a video input terminal 101; a low-pass filter (LPF) 110 for separating a luminance signal; a frequency modulator 111 for modulating the luminance signal; a band-pass filter (BPF) 112 for separating a chrominance signal; a frequency converter 113 for converting the chrominance signal to a lower frequency; an adder 114 for adding the frequency-modulated luminance signal and the frequency-converted chrominance signal to each other; a recording lamp 115; video signal recording/reproducing heads 116a and 116b; an audio signal input terminal 102; an A/D converter 120; a digital processing circuit 121; an offset quadrature differential phase-shift keying (O-QDPSK) modulator 122; a band-pass filter (BPF) 123; a limiter 124; a recording amplifier 125; audio-only recording/reproducing heads 126a and 126b; a reproducing amplifier 130; a band-pass filter (BPF) 131 for separating the luminance signal; a frequency modulator 132; a low-pass filter (LPF) 133 for separating the chrominance signal; a frequency converter 134; an adder 135 for adding the luminance signal and the chrominance signal to each other; a video signal output terminal 103; a reproducing amplifier 140; a band-pass filter (BPF) 141 for separating the audio signal; an O-QDPSK demodulator 142 of the present invention; a digital processing circuit 143; a D/A converter 144; and an audio signal output terminal 104. The O-QDPSK modulator 122 and the O-QDPSK demodulator 142 may be formed by using the circuit configurations shown in Figs. 3 and 5, respectively.

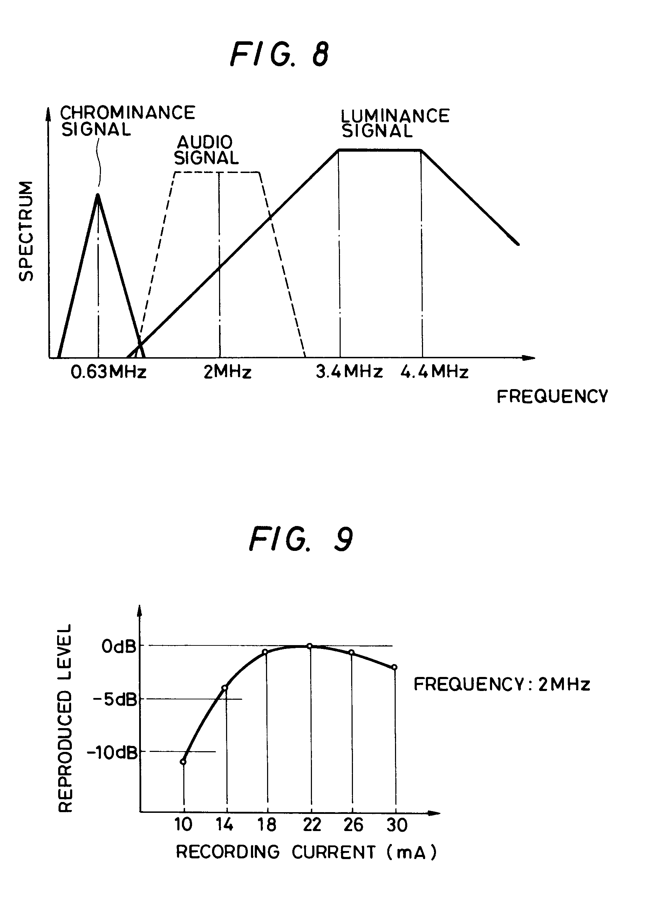

In the above constitution, the operation is performed in the following manner. The video signal passed through the LPF 110 and the BPF 112 is separated into the luminance signal and the chrominance signal, which are then frequency-modulated and frequency-converted to the bands of Fig. 8 respectively by the frequency modulator 111 and the frequency converter 113. The signals thus processed are recorded on a tape by the two video recording heads 116a and 116b disposed opposite to each other. And in a playback mode, the signal reproduced by the heads 116a and 116b is passed through the BPF 131 and LPF 133 for separation of the luminance signal and the chrominance signal, which are then processed through the frequency demodulator 132 and the frequency converter 134 respectively, so that the signals are reconverted into the former video frequency band prior to the recording mode and subsequently are fed to the adder 135 from which the original video signal is resumed.

Meanwhile, the audio signal is once converted into a digital form by the A/D converter 120, and a synchronous signal and a correction code are added thereto by the digital processing circuit 121. After interleaving, the digital audio signal is input to the O-QDPSK modulator 122, where O-QDPSK modulation is performed in such a manner that, as shown in Fig. 8, the spectrum of the audio signal is defined within the occupied band-width of the frequency-converted chrominance signal and that of the frequency-modulated luminance signal in the entire spectrum of the signal to be recorded. The O-QDPSK modulated signal is then passed through the BPF 123 and the limiter 124 so that both the bandwidth and the amplitude are limited, and subsequently the signal is recorded, prior to video recording, on a video track by means of the audio-only heads 126a and 126b which are different in azimuth angle from the video heads 116a and 116b. The O-QDPSK modulated signal thus recorded is erased in the surface part of the tape by the video signal which is recorded later, whereby a multilayer magnetic recording mode is carried out with the first-recorded audio signal remaining in the deep part of the tape.

In a playback mode, the signal reproduced by the audio-only heads 126a and 126b is passed through the BPF 141, from which the modulated audio signal is obtained. This signal is then fed to the O-QDPSK demodulator 142 and the digital processing circuit 143 to resume the former digital signal, which is further fed to the D/A converter 144 to restore the original audio signal.

By recording the audio signal after conversion into a digital form as mentioned above, it is rendered possible to attain high-quality audio transmission without harmful influence of any distortion in the recording medium. Furthermore, since the digital signal is recorded through O-QDPSK modulation with limitation of both the bandwidth and the amplitude thereof, it becomes possible to minimize the interference with the video signal while enhancing the C/N ratio of the reproduced O-QDPSK modulated signal.

Hereinafter the effects of the above embodiment will be described with reference to Figs. 9 through 11. Fig. 9 graphically shows the result of actually measuring the recording current and the reproduced output level in the characteristics of the audio-only heads 126a and 126b. Generally the magnetic head has such characteristic that, as plotted in the graph, its reproduced output increases in proportion to the recording current up to a certain level, but there exists a saturation point where the output level no further rises despite any increase of the recording current. And it is customary that the recording current is set at such saturation point for the purpose of improving the S/N ratio. However, a possibility may be induced due to the saturation that the recorded waveform is distorted to eventually generate an unnecessary spectrum which brings about interference with the video signal. Particularly in applying the QPSK system which is utilized as digital modulation in a variety of fields and is substantially equivalent to an amplitude modulation (AM) system, a side lobe comes to expand due to the saturation. In view of such disadvantage, employing the O-QPSK system is effective to minimize the amplitude variation in the recorded waveform to consequently suppress generation of any distortion that results from the saturation. And by virtue of the above-described O-QDPSK system, it is not needed to maintain the phase difference φ of the recovered carrier at 0° under control, hence simplifying the demodulator circuit configuration.

For recording the PCM audio signal on a multilayer medium without changing the frequency arrangement of the video signal used in the VTR available today, it is preferred to employ the technique of audio deep-part recording. In a deep-part recording operation where the PCM audio signal is erased in the surface part of the recording medium by the video signal superposed thereon, it is necessary to raise the reproduction level of the PCM audio signal as high as possible to achieve saturation recording. As the signal is saturated in such recording and its waveform is thereby distorted, the O-QPSK system is preferred for modulation. Since in the O-QPSK system some obscurity of n x 90° (n = integer) is residual in the recovered reference carrier as mentioned, differential coding is executed on the transmitter side while inverse differential decoding is executed on the receiver side so as to attain exact demodulation despite such obscurity. The above is the feature of the O-QDPSK system which is adapted to provide an optimal modulator/demodulator.

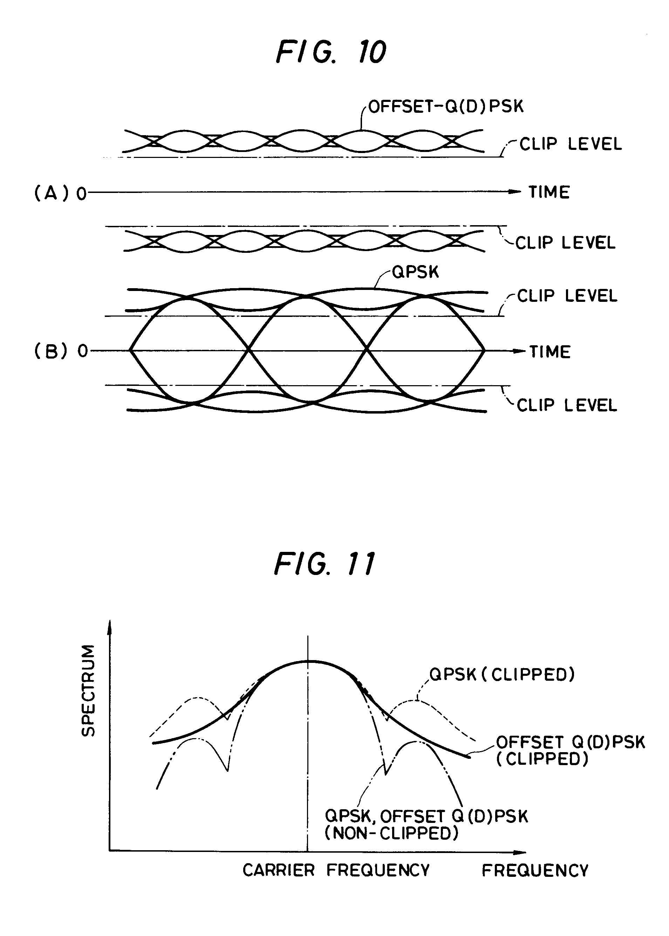

Figs. 10 and 11 show the effects of the above-mentioned embodiment, in which Fig. 10 (A) and (B) represent the envelope of O-Q(D)PSK modulated waves and that of QPSK modulated waves, respectively. In the O-Q(D)PSK system, the amplitude variation is reduced as compared with the QPSK system. And saturation of such waveform is equivalent to clipping thereof at a certain level denoted by a one-dot chain line. Fig. 11 graphically shows the spectra obtained in such a state, wherein a solid line and a broken line respectively denote the spectrum in the O-Q(D)PSK system and that in the QPSK system. And a two-dot chain line denotes the spectrum obtained at the time of nonsaturation without clipping. In this case, the spectrum is the same in both systems. As described, the O-Q(D)PSK system is advantageous with respect to that the spectrum is kept free from expansion regardless of such clipping, and consequently interference with the video signal is substantially nil in recording the digital audio signal by the use of this system.

In view of the fact that the spectrum is not expanded despite clipping of the aforementioned O-Q(D)PSK modulated signal, the embodiment of Fig. 7 is so contrived as to perform a recording operation with a constant amplitude through the limiter 123 to limit the amplitude variation residual in the O-Q(D)PSK modulated signal, hence accomplishing complete saturation recording to eventually improve the C/N ratio of the reproduced signal as well as to reduce the coding error rate relative to the demodulated data.

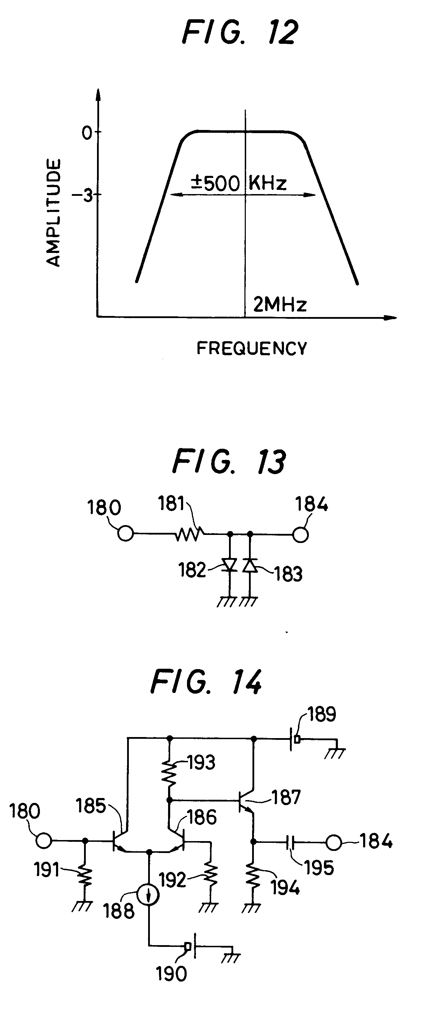

Fig. 12 graphically shows exemplary frequency characteristic of the BPF 123 in the digital audio signal recording circuit shown in Fig. 7. Assuming now that the converted digital audio signal is processed at a code transmission rate of 2M bits/sec, the minimum necessary bandwidth is ±500 kHz in QDPSK modulation. In such a case, if the bandwidth of the BPF 123 is set at ±500 kHz to completely eliminate the side lobe of the modulated signal spectrum, then substantially no interference is generated with the video signal.

Fig. 13 is an exemplary circuit diagram of the limiter 124, wherein an input signal fed to an input terminal 180 is passed through a resistor 181 and diodes 182 and 183, so that the signal amplitude is limited to the threshold voltage (about 0.7 V) of the diodes in both positive and negative polarities, and the signal thus limited is obtained from an output terminal 184. Fig. 14 is another exemplary circuit diagram of the limiter 124, wherein a differential amplifier comprising transistors 185 and 186 is employed to attain the limiter effect. Although a variety of circuit configurations may be contrived with respect to the limiter 124 as mentioned, it is not limited to the above examples alone.

In the aforesaid embodiment of the present invention shown in Fig. 7, the BPF 123 and the limiter 124 are disposed posterior to the O-QDPSK modulator 122. However, substantially the same effect as in the above embodiment can be achieved even with omission of the limiter 124 and/or the BPF 123.

As described hereinabove, a multilayer recording operation is performed in the exemplary embodiment of the present invention, wherein the video signal is composed of a frequency-modulated luminance signal and a frequency-converted chrominance signal, and superposition recording is executed by video and audio heads which are different in azimuth angle from each other. However, the feature of the above embodiment resides in extremely narrowing the occupied bandwidth of the digital audio recording signal to suppress the mutual interference with the video recording signal. Therefore, the recording mode is not restricted to such multilayer recording alone and may be ordinary multifrequency recording as well. Furthermore, in case the video signal is processed by a time-division multiplex method with regard to its luminance and chrominance signals, multifrequency recording may be executed by selectively setting the occupied band of the digital audio recording signal outside that of the frequency-modulated video signal. In another case of parallel-recording the luminance signal and the chrominance signal in individual tracks, the digital audio signal may be multifrequency-recorded in either of such tracks in a manner that the respective occupied bands are not overlapped.

**Claims**

1. A recording and reproducing apparatus wherein a video signal including a chrominance signal and a luminance signal, and an information signal like an audio signal are recorded on the same track of a recording medium; comprising:

first processing means (110, 111, 112, 113, 114) for frequency-modulating the luminance signal and for frequency-converting the chrominance signal to be recorded into a chrominance recording signal having a predetermined frequency band which is lower than that of the frequency-modulated luminance signal, the frequency-modulated signal and the frequency-converted signal forming a video recording signal;

second processing means (120, 121) for converting the information signal to be recorded into a digital information signal which is modulated by a modulator means (122) for subjecting a carrier to a modulation with the digital information signal so that a frequency band of a signal modulated with the digital information signal is disposed on the high frequency side of an occupied band of a chrominance signal component in the chrominance recording signal,

first magnetic head means (126a, 126b) for recording an output signal of said modulator means (122) in a deep layer of said recording medium along a recording track thereof prior to recording of the video recording signal along said recording track and for reproducing the recorded output signal;

second magnetic head means (116a, 116b) being different in azimuth from said first magnetic head means (126a, 126b) for recording the video recording signal in a surface layer of said recording medium along said recording track and in superposition on the previously recorded output signal of said modulator means (122) and for reproducing the recorded video recording signal;

third processing means (143, 144) for converting the digital information signal reproduced by said first magnetic head means (126a, 126b) and demodulated by a demodulator means (142) into the information signal; and

fourth processing means (131, 132, 133, 134, 135) for converting the signal reproduced by said second magnetic head means (116a, 116b) into the video signal;

**characterized in that**

said modulator means (122) is an offset quadrature **PSK** modulator, whereby a side lobe of the offset quadrature **PSK** modulated digital information signal which appears in the occupied band of the chrominance signal component is reduced not to be substantially reproduced by the second magnetic head means (116a, 116b); and

said demodulator means (142) is an offset quadrature **PSK** demodulator for subjecting the signal reproduced from said deep layer of said recording medium by said first magnetic head means (126a, 126b) to an offset quadrature **PSK** demodulation so as to produce the digital information signal.

2. An apparatus for recording a video signal including a chrominance signal and a luminance signal, and an information signal like an audio signal recorded on the same track of a recording medium; comprising:

first processing means (110-114) for frequency-modulating the luminance signal and for frequency-converting the chrominance signal to be recorded into a chrominance recording signal having a predetermined frequency band which is lower than that of the frequency-modulated luminance signal, the frequency-modulated signal and the frequency-converted signal forming a video recording signal;

second processing means (120, 121) for converting the information signal to be recorded into a digital information signal which is modulated by a modulator means (122) for subjecting a carrier to a modulation with the digital information signal so that a frequency band of a signal modulated with the digital information signal is disposed on the high frequency side of an occupied band of a chrominance signal component in the chrominance recording signal,

first magnetic head means (126a, 126b) for recording an output signal of said modulator means (122) in a deep layer of said recording medium along a recording track thereof prior to recording of the video recording signal along said recording track;

second magnetic head means (116a, 116b) being different in azimuth from said first magnetic head means (126a, 126b) for recording the video recording signal in a surface layer of said recording medium along said recording track and in superposition on the previously recorded output signal of said modulator means (122);

**characterized in that**

said modulator means (122) is an offset quadrature **PSK** modulator, whereby a side lobe of the offset quadrature **PSK** modulated digital information signal which appears in the occupied band of the

9

chrominance signal component is reduced not to be substantially reproduced by the second magnetic head means (116a, 116b).

3. An apparatus according to claim 1 or 2, characterized in that said frequency band of the signal modulated with the digital information signal is disposed below a carrier frequency of the frequency-modulated luminance signal component in the video recording signal.

4. An apparatus according to any of claims 1 to 3, characterized in that said modulation/demodulation is an offset quadrature differential **PSK** modulation/demodulation.

5. An apparatus according to any of claims 1 to 4, characterized by a limiter means (124) for limiting an amplitude of the signal modulated with the digital information signal prior to recording the signal modulated with the digital information signal.

6. An apparatus according to claim 5, characterized by a band-pass filter means (123) for band-pass filtering the signal modulated with the digital information signal prior to limiting the amplitude of the signal modulated with the digital information signal.

7. A method for recording a video signal including a chrominance signal and a luminance signal and an information signal like an audio signal recorded on the same track of a recording medium; said method comprising the steps of:
frequency-modulating (110, 111) the luminance signal, frequency-converting (112, 113) the chrominance signal to be recorded into a chrominance recording signal having a predetermined frequency band which is lower than that of the frequency-modulated luminance signal and forming (114) a video recording signal from the frequency-modulated signal and the frequency-converted signal;
converting (120, 121) the information signal to be recorded into a digital information signal,
modulating (122) a carrier with the digital information signal, said modulating step (122) subjects a carrier to modulation with the digital information signal so that a frequency band of a signal modulated with the digital information signal is disposed on the high frequency side of an occupied band of a chrominance signal component in the chrominance recording signal,
recording (126a, 126b) the modulated digital information signal with a first azimuth angle, said first recording step (126a, 126b) records the output signal of said modulating step (122) in a deep layer of said recording medium along a recording track thereof prior to recording of the video recording signal along said recording track,
recording (116a, 116b) the video recording signal with a second azimuth angle being different from said first azimuth angle, said second recording step (116a, 116b) records the video recording signal in a surface layer of said recording medium along said recording track and in superposition on the previously recorded signal modulated with the digital information signal,
**characterized in that**
said modulating step (122) is an offset quadrature **PSK** modulation, whereby a side lobe of the offset quadrature **PSK** modulated digital information signal which appears in the occupied band of the chrominance signal component is reduced not to be substantially reproduced when reproducing the recorded video recording signal.

8. A method according to claim 7, characterized in that said frequency band of the signal modulated with the digital information signal is disposed below a carrier frequency of a frequency-modulated luminance signal component in the video recording signal.

9. A method according to claim 7 or 8, characterized in that said modulation is an offset quadrature differential **PSK** modulation.

10. A method according to any of claims 7 to 9, characterized by a step of limiting (124) an amplitude of the signal modulated with the digital information signal prior to recording the signal modulated with the digital information signal.

11. A method according to claim 10, characterized by a step of band-pass filtering (123) the signal modulated with the digital information signal prior to limiting the amplitude of the signal modulated with the digital information signal.

EP 0 206 203 B1

**Patentansprüche**

1. Aufzeichnungs- und Wiedergabegerät, wobei ein Videosignal mit einem Chrominanzsignal und einem Luminanzsignal und ein Informationssignal wie ein Audiosignal auf derselben Spur eines Aufzeichnungsmediums aufgezeichnet werden; wobei das Gerät folgendes aufweist:

eine erste Verarbeitungseinrichtung (110, 111, 112, 113, 114) zum Frequenzmodulieren des Luminanzsignals und zum Frequenzwandeln des aufzuzeichnenden Chrominanzsignals in ein Chrominanz-Aufzeichnungssignal mit einem vorbestimmten Frequenzband, das niedriger als jenes des frequenzmodulierten Luminanzsignals ist, wobei das frequenzmodulierte Signal und das frequenzgewandelte Signal ein Video-Aufzeichnungssignal bilden;

eine zweite Verarbeitungseinrichtung (120, 121) zum Umwandeln des aufzuzeichnenden Informationssignals in ein Digital-Informationssignal, das durch eine Modulatoreinrichtung (122) moduliert ist, um einen Träger einer Modulation mit dem Digital-Informationssignal auszusetzen, so daß ein Frequenzband eines Signals, das mit dem Digital-Informationssignal moduliert ist, auf der Hochfrequenzseite eines besetzten Bandes einer Chrominanz-Signalkomponente in dem Chrominanz-Aufzeichnungssignal angeordnet ist;

eine erste Magnetkopfeinrichtung (126a, 126b) zum Aufzeichnen eines Ausgangssignals der Modulatoreinrichtung (122) in einer tiefen Schicht des Aufzeichnungsmediums entlang einer Aufzeichnungsspur davon vor einem Aufzeichnen des Video-Aufzeichnungssignals entlang der Aufzeichnungsspur und zum Wiedergeben des aufgezeichneten Ausgangssignals;

eine zweite Magnetkopfeinrichtung (116a, 116b), die bezüglich des Azimuths unterschiedlich von der ersten Magnetkopfeinrichtung (126a, 126b) ist, zum Aufzeichnen des Video-Aufzeichnungssignals in einer Oberflächenschicht des Aufzeichnungsmediums entlang der Aufzeichnungsspur und in einer Überlagerungsposition auf dem zuvor aufgezeichneten Ausgangssignal der Modulatoreinrichtung (122) und zum Wiedergeben des aufgezeichneten Video-Aufzeichnungssignals;

eine dritte Verarbeitungseinrichtung (143, 144) zum Umwandeln des Digital-Informationssignals, das durch die erste Magnetkopfeinrichtung (126a, 126b) wiedergegeben und durch eine Demodulatoreinrichtung (142) demoduliert ist, in das Informationssignal; und

eine vierte Verarbeitungseinrichtung (131, 132, 133, 134, 135) zum Umwandeln des Signals, das durch die weite Magnetkopfeinrichtung (116a, 116b) wiedergegeben ist, in das Videosignal;

**dadurch gekennzeichnet,** daß

die Modulatoreinrichtung (122) ein OQPSK-Modulator (= MOdulator zur verschobenen quaternären Freqenzumtastung) ist, wodurch ein Seitenband des OQPSK-modulierten Digital-Informationssignal, das in dem besetzten Band der Chrominanz-Signalkomponente auftritt, reduziert wird, um im wesentlichen nicht durch die zweite Magnetkopfeinrichtung (116a, 116b) wiedergegeben zu werden; und

die Demodulatoreinrichtung (142) ein OQPSK-Demodulator ist zum Aussetzen des Signals, das aus der tiefen Schicht des Aufzeichnungssmediums durch die erste Magnetkopfeinrichtung (126a, 126b) wiedergegeben ist, einer OQPSK-Demodulation, um das Digital-Informationssignal zu erzeugen.

2. Gerät zum Aufzeichnen eines Videosignals mit einem Chrominanzsignal und einem Luminanzsignal und eines Informationssignals wie ein Audiosignal, die auf derselben Spur eines Aufzeichnungsmediums aufgezeichnet werden, wobei das Gerät folgendes aufweist:

eine erste Verarbeitungseinrichtung (110 - 114) zum Frequenzmodulieren des Luminanzsignals und zum Frequenzwandeln des aufzuzeichnenden Chrominanzsignals in ein Chrominanz-Aufzeichnungssignal mit einem vorbestimmten Frequenzband, das niedriger als jenes des frequenzmodulierten Luminanzsignals ist, wobei das frequenzmodulierte Signal und das frequenzgewandelte Signal ein Video-Aufzeichnungssignal bilden;

eine zweite Verarbeitungseinrichtung (120, 121) zum Umwandeln des aufzuzeichnenden Informationssignals in ein Digital-Informationssignal, das durch eine Modulatoreinrichtung (122) moduliert wird, zum Aussetzen eines Trägers einer Modulation mit dein Digital-Informationssignal, so daß ein Frequenzband eines Signals, das mit dem Digital-Informationssignal moduliert ist, auf der Hochfrequenzseite eines besetzten Bandes einer Chrominanz-Signalkomponente in dem Chrominanz-Aufzeichnungssignal angeordnet ist,

eine erste Magnetkopfeinrichtung (126a, 126b) zum Aufzeichnen eines Ausgangssignals der Modulatoreinrichtung (122) in einer tiefen Schicht des Aufzeichnungsmediums entlang einer Aufzeichnungsspur davon vor einem Aufzeichnen des Video-Aufzeichnungssignals entlang der Aufrechnungsspur;

eine zweite Magnetkopfeinrichtung (116a, 116b), die bezüglich des Azimuths unterschiedlich von der ersten Magnetkopfeinrichtung (126a, 126b) ist, zum Aufzeichnen des Video-Aufzeichnungssignals in

11

einer Oberflächenschicht des Aufzeichnungsmediums entlang der Aufzeichnungsspur und in einer Überlagerungsposition auf dem zuvor aufgezeichneten Ausgangsignal der Modulatoreinrichtung (122); **dadurch gekennzeichnet,** daß

die Modulatoreinrichtung (122) ein OQPSK-Modulator ist, wodurch ein Seitenband des OQPSK-modulierten Digital-Informationssignal, das in dem besetzten Band der Chrominanz-Signalkomponente auftritt, reduziert wird, um im wesentlichen nicht durch die zweite Magnetkopfeinrichtung (116a, 116b) wiedergegeben zu werden.

3. Gerät nach Anspruch 1 oder 2, dadurch gekennzeichnet, daß das Frequenzband des Signals, das mit dem Digital-Informationssignal moduliert ist, unterhalb einer Trägerfrequenz der frequenzmodulierten Luminanz-Signalkomponente in dem Video-Aufzeichnungssignal angeordnet ist.

4. Gerät nach einem der Ansprüche 1 bis 3, dadurch gekennzeichnet, daß die Modulation/Demodulation eine differentielle OQPSK-Modulation/Demodulation ist.

5. Gerät nach einem der Ansprüche 1 bis 4, gekennzeichnet durch eine Begrenzereinrichtung (124) zum Begrenzen einer Amplitude des Signals, das mit dem Digital-Informationssignal moduliert ist, vor einem Aufzeichnen des Signals, das mit dem Digital-Informations-Signal moduliert ist.

6. Gerät nach Anspruch 5, gekennzeichnet durch eine Bandpaß-Filtereinrichtung (123) zum Bandpaßfiltern des Signals, das mit dem Digital-Informationssignal moduliert wird, vor einem Begrenzen der Amplitude des Signals, das mit dem Digital-Informationssignal moduliert wird.

7. Verfahren zum Aufzeichnen eines Videosignals mit einem Chromonanzsignal und einem Luminanzsignal und eines Informationssignals wie ein Audiosignal, die auf derselben Spur eines Aufzeichnungsmediums aufgezeichnet werden, wobei das Verfahren folgende Schritte aufweist:
Frequenzmodulieren (110, 111) des Luminanzsignals, Frequenzwandeln (112, 113) des aufzeichnenden Chrominanzsignals in ein Chrominanz-Aufzeichnungssignal mit einem vorbestimmten Frequenzband, das niedriger als jenes des frequenzmodulierten Luminanzsignals ist, und Bilden (114) eines Video-Aufzeichnungssignals aus dem frequenzmodulierten Signal und dem frequenzgewandelten Signal;
Umwandeln (120, 121) des aufzuzeichnenden Informationssignals in ein Digital-Informationssignal,
Modulieren (122) eines Trägers mit dem Digital-Informationssignal, wobei der Modulierschritt (122) einen Träger einer Modulation mit dem Digital-Informationssignal aussetzt, so daß ein Frequenzband eines Signals, daß mit dem Digital-Informationssignal moduliert wird, auf der Hochfrequenzseite eines besetzten Bandes einer Chrominanz-Signalkomponente in dem Chrominanz-Aufzeichnungssignal angeordnet wird,
Aufzeichnen (126a, 126b) des modulierten Digital-Informationssignal mit einem ersten Azimuth-Winkel, wobei der erste Aufzeichnungsschritt (126a, 126b) das Ausgangssignal des Modulierschritts (122) in einer tiefen Schicht des Aufzeichnungsmediums entlang einer Aufzeichnungsspur davon vor einem Aufzeichnen des Video-Aufzeichnungssignals entlang der Aufzeichnungsspur aufzeichnet,
Aufzeichnen (116a, 116b) des Video-Aufzeichnungssignals mit einem zweiten Azimuth-Winkel, der unterschiedlich von dem ersten Azimuth-Winkel ist, wobei der zweite Aufzeichnungsschritt (116a, 116b) das Video-Aufzeichnungssignal in einer Oberflächenschicht des Aufzeichnungsmediums entlang der Aufzeichnungsspur und in einer Überlagerungsposition auf dem zuvor aufgezeichneten Signal, das mit dem Digital-Informationssignal moduliert ist, aufzeichnet,
**dadurch gekennzeichnet,** daß
der Modulierschritt (122) eine OQPSK-Modulation ist, wodurch ein Seitenband des OQPSK-modulierten Digital-Informationssignal, das in dem besetzten Band der Chrominanzsignal-Komponente auftritt, reduziert wird, um im wesentlichen nicht beim Wiedergeben des aufgezeichneten Video-Aufzeichnungssignal wiedergegeben zu werden.

8. Verfahren nach Anspruch 7, dadurch gekennzeichnet, daß das Frequenzband des Signals, das mit dem Digital-Informationssignal moduliert ist, unterhalb einer Trägerfrequenz einer frequenzmodulierten Luminanz-Signalkomponente in dem Video-Aufzeichnungssignal angeordnet wird.

9. Verfahren nach Anspruch 7 oder 8, dadurch gekennzeichnet, daß die Modulation eine differentielle OQPSK-Modulation ist.

**10.** Verfahren nach einem der Ansprüche 7 bis 9, gekennzeichnet durch einen Schritt zum Begrenzen (124) einer Amplitude des Signals, das mit dem Digital-Informationssignal moduliert wird, vor einem Aufzeichnen des Signals, das mit dem Digital-Informationssignal moduliert ist.

**11.** Verfahren nach Anspruch 10, gekennzeichnet durch einen Schritt zum Bandpaßfiltern (123) des Signals, das mit dem Digital-Informationssignal moduliert wird, vor dem Begrenzen der Amplitude des Signals, das mit dem Digital-Informationssignal moduliert wird.

**Revendications**

**1.** Dispositif d'enregistrement et de lecture, dans lequel un signal vidéo comprenant un signal de chrominance et un signal de luminance, et un signal d'information tel qu'un signal audio sont enregistrés sur la même piste d'un support d'enregistrement; comprenant :
des premiers moyens de traitement (110, 111, 112, 113, 114) pour moduler en fréquence le signal de luminance et appliquer une conversion de fréquence au signal de chrominance devant être enregistré pour le convertir en un signal d'enregistrement de chrominance possédant une bande prédéterminée de fréquences, qui est inférieure à celle du signal de luminance modulé en fréquence, le signal modulé en fréquence et le signal ayant subi la conversion de fréquence constituant un signal d'enregistrement vidéo;
des seconds moyens de traitement (120, 121) pour convertir le signal d'information devant être enregistré en un signal d'information numérique, qui est modulé par des moyens modulateurs (122) pour soumettre une porteuse à une modulation par le signal d'information numérique de sorte qu'une bande de fréquences d'un signal modulé par le signal d'information numérique est située sur le côté des hautes fréquences d'une bande occupée d'une composante du signal de chrominance dans le signal d'enregistrement de chrominance,
des premiers moyens formant têtes magnétiques (126a, 126b) pour enregistrer un signal de sortie desdits moyens modulateurs (122) dans une couche profonde dudit support d'enregistrement le long d'une piste d'enregistrement de ce support, avant l'enregistrement du signal d'enregistrement vidéo le long de ladite piste d'enregistrement et pour la lecture du signal de sortie enregistré;
des seconds moyens formant têtes magnétiques (116a, 116b), qui possèdent un azimut différent desdits premiers moyens formant têtes magnétiques (126a, 126b) pour l'enregistrement du signal d'enregistrement vidéo dans une couche superficielle dudit support d'enregistrement le long de ladite piste d'enregistrement et en superposition avec le signal de sortie, enregistré précédemment, desdits moyens modulateurs (122) et pour la lecture du signal d'enregistrement vidéo enregistré;
des troisièmes moyens de traitement (143, 144) pour convertir le signal d'information numérique lu par lesdits premiers moyens formant têtes magnétiques (126a, 126b) et démodulé par des moyens démodulateurs (142) en le signal d'information; et
des quatrièmes moyens de traitement (131, 132, 133, 134, 135) pour convertir le signal lu par lesdits seconds moyens formant têtes magnétiques (116a, 116b) en le signal vidéo;
caractérisé en ce que
lesdits moyens modulateurs (122) sont constitués par un modulateur MDP en quadrature à décalage, ce qui a pour effet qu'un lobe latéral du signal d'information numérique modulé selon la modulation MDP en quadrature à décalage, qui apparaît dans la bande occupée de la composante du signal de chrominance, est réduit de manière à ne pas être, pour l'essentiel, lu par les seconds moyens formant têtes magnétiques (116a, 116b); et
lesdits moyens démodulateurs (142) sont constitués par un démodulateur MDP en quadrature à décalage servant à soumettre le signal lu à partir de ladite couche profonde dudit support d'enregistrement par lesdits premiers moyens formant têtes magnétiques (126a, 126b) à une démodulation MDP en quadrature à décalage de manière à produire le signal d'information numérique.

**2.** Dispositif pour enregistrer un signal vidéo comprenant un signal de chrominance et un signal de luminance, et un signal d'information tel qu'un signal audio, qui sont enregistrés sur la même piste d'un support d'enregistrement; comprenant :
des premiers moyens de traitement (110-114) pour moduler en fréquence le signal de luminance et appliquer une conversion de fréquence au signal de chrominance devant être enregistré pour le convertir en un signal d'enregistrement de chrominance possédant une bande prédéterminée de fréquences, qui est inférieure à celle du signal de luminance modulé en fréquence, le signal modulé en fréquence et le signal ayant subi la conversion de fréquence constituant un signal d'enregistrement vidéo;

des seconds moyens de traitement (120, 121) pour convertir le signal d'information devant être enregistré en un signal d'information numérique, qui est modulé par des moyens modulateurs (122) pour soumettre une porteuse à une modulation par le signal d'information numérique de sorte qu'une bande de fréquences d'un signal modulé par le signal d'information numérique est située sur le côté des hautes fréquences d'une bande occupée d'une composante du signal de chrominance dans le signal d'enregistrement de chrominance,

des premiers moyens formant têtes magnétiques (126a, 126b) pour enregistrer un signal de sortie desdits moyens modulateurs (122) dans une couche profonde dudit support d'enregistrement le long d'une piste d'enregistrement de ce support, avant l'enregistrement du signal d'enregistrement vidéo le long de ladite piste d'enregistrement;

des seconds moyens formant têtes magnétiques (116a, 116b), qui possèdent un azimut différent desdits premiers moyens formant têtes magnétiques (126a, 126b) pour l'enregistrement du signal d'enregistrement vidéo dans une couche superficielle dudit support d'enregistrement le long de ladite piste d'enregistrement et en superposition avec le signal de sortie, enregistré précédemment, desdits moyens modulateurs (122);

caractérisé en ce que

lesdits moyens modulateurs (122) sont constitués par un modulateur MDP en quadrature à décalage, ce qui a pour effet qu'un lobe latéral du signal d'information numérique modulé selon la modulation MDP en quadrature à décalage, qui apparaît dans la bande occupée de la composante du signal de chrominance, est réduit de manière à ne pas être, pour l'essentiel, lu par les seconds moyens formant têtes magnétiques (116a, 116b).

**3.** Dispositif selon la revendication 1 ou 2, caractérisé en ce que ladite bande de fréquences du signal modulé par le signal d'information numérique est située audessous d'une fréquence porteuse de la composante du signal de luminance modulé en fréquence, dans le signal d'enregistrement vidéo.

**4.** Dispositif selon l'une quelconque des revendications 1 à 3, caractérisé en ce que ladite modulation/démodulation est une modulation/démodulation MDP différentielle en quadrature à décalage.

**5.** Dispositif selon l'une quelconque des revendications 1 à 4, caractérisé par des moyens limiteurs (124) servant à limiter une amplitude du signal modulé par le signal d'information numérique avant l'enregistrement du signal modulé par le signal d'information numérique.

**6.** Dispositif selon la revendication 5, caractérisé par des moyens formant filtre passe-bande (123) pour réaliser le filtrage passe-bande du signal modulé par le signal d'information numérique avant la limitation de l'amplitude du signal modulé par le signal d'information numérique.

**7.** Procédé pour enregistrer un signal vidéo comprenant un signal de chrominance et un signal de luminance,et un signal d'information tel qu'un signal audio, qui sont enregistrés sur la même piste d'un support d'enregistrement; ledit procédé comprenant les étapes consistant à :

moduler en fréquence (110, 111) le signal de luminance, soumettre le signal de chrominance devant être enregistré à une conversion de fréquence (112, 113) pour obtenir un signal d'enregistrement de chrominance possédant une bande prédéterminée de fréquences, qui est située au-dessous de celle du signal de luminance modulé en fréquence, et former (114) un signal d'enregistrement vidéo à partir du signal modulé en fréquence et du signal ayant subi la conversion de fréquence;

convertir (120, 121) le signal d'information devant être enregistré en un signal d'information numérique, moduler (122) une porteuse avec le signal d'information numérique, ladite étape de modulation (122) soumettant une porteuse à une modulation au moyen du signal d'information numérique de sorte qu'une bande de fréquences d'un signal modulé par le signal d'information numérique est situé sur le coté des hautes fréquences d'une bande occupée d'une composante du signal de chrominance dans le signal d'enregistrement de chrominance,

enregistrer (126a, 126b) le signal d'information numérique modulé, avec un premier angle azimutal, ladite première étape d'enregistrement (126a, 126b) enregistrant le signal de sortie de ladite étape de modulation (122) dans une couche profonde dudit support d'enregistrement le long d'une piste d'enregistrement de ce support avant l'enregistrement du signal d'enregistrement vidéo le long de ladite piste d'enregistrement,

enregistrer (116a, 116b) le signal d'enregistrement vidéo avec un second angle azimutal qui diffère

14

dudit premier angle azimutal, ladite seconde étape d'enregistrement (116a, 116b) enregistrant le signal d'enregistrement vidéo dans une couche superficielle dudit support d'enregistrement le long de ladite piste d'enregistrement et en superposition avec le signal précédemment enregistré, modulé par le signal d'information numérique,

caractérisé en ce que ladite étape de modulation (122) est une modulation MDP en quadrature à décalage, ce qui a pour effet qu'un lobe latéral du signal d'information numérique modulé selon la modulation MDP en quadrature à décalage, qui apparaît dans la bande occupée de la composante du signal de chrominance, est réduit de manière à ne pas être, pour l'essentiel, lu lors de la lecture du signal d'enregistrement vidéo enregistré.

8.  Procédé selon la revendication 7, caractérisé en ce que ladite bande de fréquences du signal modulé par le signal d'information numérique est située au-dessous d'une fréquence porteuse d'une composante du signal de luminance modulé en fréquence dans le signal d'enregistrement vidéo.

9.  Procédé selon la revendication 7 ou 8, caractérisé en ce que ladite modulation est une modulation MDP différentielle en quadrature à décalage.

10. Procédé selon l'une quelconque des revendications 7 à 9, caractérisé par une étape consistant à limiter (124) une amplitude du signal modulé par le signal d'information numérique avant l'enregistrement du signal modulé par le signal d'information numérique.

11. Procédé selon la revendication 10, caractérisé par une étape de filtrage passe-bande (123) du signal modulé par le signal d'information numérique, avant la limitation de l'amplitude du signal modulé par le signal d'information numérique.

FIG. 1A

FIG. 1B

# FIG. 2

⟨i⟩ MOD. SIDE

T

(A) $X_1$ $Y_1$ $X_2$ $Y_2$ $X_3$

(B) $X_0$ $X_1$ $X_2$ $X_3$

(C) $Y_0$ $Y_1$ $Y_2$

(D) $P_0$ $P_1$ $P_2$ $P_3$

(E) $Q_0$ $Q_1$ $Q_2$

⟨ii⟩ DEMOD. SIDE, $\phi = 0°(180°)$

(F) $P_1(\bar{P}_1)$ $P_2(\bar{P}_2)$

(G) $Q_0(\bar{Q}_0)$ $Q_1(\bar{Q}_1)$ $Q_2(\bar{Q}_2)$

(H) $X_1$ $X_2$

(I) $Y_0$ $Y_1$ $Y_2$

(J) $Y_0$ $X_1$ $Y_1$ $X_2$ $Y_2$

⟨iii⟩ DEMOD. SIDE, $\phi = 90°(-90°)$

(F) $\bar{Q}_0(Q_0)$ $\bar{Q}_1(Q_1)$ $\bar{Q}_2(Q_2)$

(G) $P_1(\bar{P}_1)$ $P_2(\bar{P}_2)$

(H) $Y_0$ $Y_1$ $Y_2$

(I) $X_1$ $X_2$

(J) $Y_0$ $X_1$ $Y_1$ $X_2$ $Y_2$

# FIG. 3

# FIG. 4

# FIG. 5

EP 0 206 203 B1

# FIG. 6

⟨i⟩ φ=0° (180°)

(F) $P_0(\bar{P}_0)$ $P_1(\bar{P}_1)$ $P_2(\bar{P}_2)$

(G) $Q_{-1}(\bar{Q}_{-1})$ $Q_0(\bar{Q}_0)$ $Q_1(\bar{Q}_1)$ $Q_2(\bar{Q}_2)$

(H) $X_0$ $X_1$ $X_2$

(I) $Y_{-1}$ $Y_0$ $Y_1$ $Y_2$

CK2'

(L) $X_0$ $X_1$ $X_2$

(M) $Y_0$ $Y_1$ $Y_2$

(J) $Y_{-1}$ $X_0$ $Y_0$ $X_1$ $Y_1$ $X_2$ $Y_2$

CK1'

⟨ii⟩ φ = 90° (−90°)

(H) $Y_{-1}$ $Y_0$ $Y_1$ $Y_2$

(I) $X_0$ $X_1$ $X_2$

CK2'

(L) $Y_0$ $Y_1$ $Y_2$

(M) $X_0$ $X_1$ $X_2$

(J) $Y_{-1}$ $X_0$ $Y_0$ $X_1$ $Y_1$ $X_2$ $Y_2$

CK1'

20

FIG. 7

# FIG. 8

# FIG. 9

## FIG. 10

OFFSET–Q(D)PSK

CLIP LEVEL

(A) 0 —————————————————→ TIME

CLIP LEVEL

QPSK

CLIP LEVEL

(B) 0 —————————————————→ TIME

CLIP LEVEL

## FIG. 11

SPECTRUM

QPSK (CLIPPED)

OFFSET Q(D)PSK
(CLIPPED)

QPSK, OFFSET Q(D)PSK
(NON–CLIPPED)

CARRIER FREQUENCY        FREQUENCY

# FIG. 12

# FIG. 13

# FIG. 14